# EUROPÄISCHE PATENTANMELDUNG

(11) **EP 1 041 759 A2**
(43) Veröffentlichungstag der Anmeldung: **04.10.2000**
(21) Anmeldenummer: 00106866.7
(22) Anmeldetag: 30.03.2000
(51) Int. Cl.: H04J 3/06, H04B 7/26, H04L 7/04

(54) **Verfahren und Vorrichtung zur digitalen Rahmensynchronisation eines Übertragungssignals**

(30) Priorität: 01.04.1999 DE 19915163
(71) Anmelder: IAD Gesellschaft für Informatik, Automatisierung und Datenverarbeitung mbH, 90613 Grosshabersdorf (DE)
(72) Erfinder: Hampel, Hermann, Dipl.-Ing., 90613 Grosshabersdorf (DE); Stöger, Matthias, Dipl.-Ing., 90409 Nürnberg (DE)
(74) Vertreter: Dreykorn-Lindner, Werner, Dipl.-Ing.

(57) **Zusammenfassung**

Für unterschiedlich ausgestaltete Kommunikationssysteme mit burstartiger Übertragung ist die Verwendung einer Präambel am Beginn eines Sendetelegramms bekannt. In der Regel wird zwischen dem ersten Präambelteil, der zur Einstellung der AGC dient, und der eigentlichen Synchronisationssequenz, entweder zu Lasten der Effizienz eine Sendepause eingefügt ( 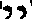 dead time") oder aber es wird eine erhöhte Fehldetektion in Kauf genommen.

Um bei blockweiser Übertragung von Daten, ein schnelles und sicheres Einschwingen der AGC zu gewährleisten und darüber hinaus - ohne Effizienzverlust durch Verwendung von Sendepausen - eine zuverlässige Synchronisation und Signalisierung, bei der Fehldetektionen möglichst ausgeschlossen werden, zu ermöglichen, ist erfindungsgemäß vorgesehen, dass die Präambel aus einem AGC-Block zum Einschwingen der AGC-Regelung und einer Synchronisationssequenz zur Rahmensynchronisation sowie zur Signalisierung besteht, wobei der verfügbare Frequenzbereich im Basisband in drei überlappungsfreie Teile derart aufgeteilt wird, dass dem Bereich um die Frequenz Null der AGC-Block zugeordnet ist und die Unterscheidung von Signalisierungen nach Maßgabe der Übertragung der Synchronisationssequenzen in der Regel- oder Kehrlage erfolgt.

Die Erfindung liegt auf dem Gebiet Nachrichtenübertragungssysteme.

## Beschreibung

Die Erfindung betrifft in erster Linie ein Verfahren zur digitalen Rahmensynchronisation eines Übertragungssignals, bei dem die Signalübertragung in Form von Bursts sowohl in Richtung Punkt-zu-Mehrpunkt als auch in Richtung Mehrpunkt-zu-Punkt im Vielfachzugriff erfolgt und bei dem die Bursts neben den Nutzdaten eine Präambel aufweisen (Oberbegriff des Patentanspruchs 1). Weiterhin betrifft die Erfindung eine Vorrichtung zur digitalen Rahmensynchronisation eines Übertragungssignals gemäß dem Oberbegriff des Patentanspruchs 6.

Bei drahtgebundenen oder drahtlosen Punkt zu Mehrpunkt-Übertragungsverfahren, wie beispielsweise passiven optischen Netzen, Koaxialkabelnetzen, Automatisierungssystemen oder Funksystemen mit Rückkanal, Satellitenverbindungen kommunizieren mehrere Teilnehmer mit einer Zentrale; meist wird dabei ein TDM/TDMA-Verfahren benutzt. So ist beispielsweise aus der DE 197 26 009 A1 ein Signalübertragungsverfahren für optische Netze bekannt, bei dem die Bursts an wenigstens einem Splitter zu einem TDMA-Signal für die Kopfstation zusammengefasst werden und sich die übertragenen Nutzdaten aus den einzelnen den Mehrpunkt-Stationen zugeordneten und in einem Rahmen zusammengefassten Kontrollkanälen und Datenkanälen zusammensetzen, wobei die Kontrollkanäle und die Datenkanäle für jede Mehrpunkt-Station getrennt übertragen werden. Hierdurch können die Übertragungskapazitäten, d.h. die Anzahl der Datenkanäle pro Station während des Betriebs verändert werden, ohne dass eine Verschiebung der Kontrollkanäle notwendig ist und es kann ein sogenanntes bandwidth-on-demand-fähiges Nachrichtenübertragungssystem aufgebaut werden.

Ein Verfahren zur Taktphasenrückgewinnung aus empfangenen Burstsignalen - die von einer Vielzahl externer Stationen zu einer Zentralstation im Zeitvielfachzugriff übertragen werden und die am Anfang ein Pilotsignal, gefolgt von einer Präambel und dem eigentlichen Datensignal enthalten - ist aus der DE 195 11 404 A1 bekannt. Dabei wird das Pilotsignal des empfangenen Burstsignals ausgewertet und ein erstes Steuersignal zur Aktivierung eines ersten gesteuerten Umschalters erzeugt. Weiterhin wird aus dem empfangenen Burstsignal ein um eine halbe Bittaktperiode verzögertes Burstsignal sowie ein erstes Taktsignal mit einer gegenüber letzterem verdoppelten Taktfrequenz erzeugt. Danach wird ein Phasenvergleich zwischen dem ersten Taktsignal und einem Zentraltakt der Zentralstation als Referenzsignal vorgenommen und den Taktabweichungen entsprechende Differenzspannungen erzeugt. Aus den Differenzspannungen wird ein zweites, Umschaltbefehle enthaltendes Steuersignal für den ersten gesteuerten Umschalter erzeugt, wobei den Signaleingängen des ersten gesteuerten Umschalters das unverzögerte und das verzögerte Burstsignal jeweils getrennt zugeführt werden. Dadurch erfolgt eine Umschaltung zwischen den Signaleingängen des ersten gesteuerten Umschalters nur während des Empfangs der Präambel und am Signalausgang des ersten gesteuerten Umschalters wird ein phasenmässig dem Zentraltakt angenähertes Datensignal abgegeben. Pilotsignal und Präambel dienen beim vorstehend beschriebenen Verfahren zur Taktphasenrückgewinnung und Pegeleinmessung.

Ergänzend ist hierzu aus der DE 195 11 403 A1 ein Verfahren zur automatischen Bursterkennung bei Vielfachzugriffsverfahren vorzugsweise in TDM/TDMA-Systemen - bei denen vor dem zu übertragenden Nutzdatenblock eine aus mehreren Bit bestehende Präambel übertragen wird - bekannt, bei dem vor der Aussendung der Präambel für vergleichsweise kurze Zeit ein Pilotsignal mit vergleichsweise hoher Amplitude ausgesendet wird, dessen Frequenz sich bei einer Nullstelle des für die Nutzsignalübertragung verwendeten Codes oder außerhalb des Signalspektrums des Nutzsignals befindet. Aus dem übertragenen Pilotsignal wird empfangsseitig ein Steuersignal erzeugt, welches die empfangsseitige Taktrückgewinnungsschaltung und/oder die empfangsseitige Pegelregelung aktiviert.

Weiterhin sind Nachrichtenübertragungssysteme bekannt, bei denen die Information über das Medium Energiekabel verteilt wird. Die Topologie der Übertragungsstrecke zwischen Trafostation und Hausanschlußkasten ist in diesen sogenannten PLC-Systemen (Power Line Communication) meist eine Punkt-zu-Mehrpunkt-Struktur mit der Trafosstation als Knotenpunkt. In der Regel erfolgt die Datenübertragung unter Benutzung der CPFSK (phase continuous frequency shift keying) und der Netzfrequenz als Referenzsignal zur Synchronisierung einer FSK-Übertragung im korrelativ auswertenden Empfänger. Wie beispielsweise in der DE 197 04 018 A1 beschrieben ist, kann das Datentelegramm eine vorangestellte 4-Bit-Trainingssequenz, eine 16-Bit Präambel und einen Nachrichtenteil aufweisen. Um auch bei starken Netzfrequenzschwankungen eine ausreichend gute Synchronisation für die Auswertung langer Datentelegramme zu erreichen, wird sendeseitig eine von der Nennfrequenz durch Vervielfachung abgeleitet Baudrate verwendet. Die Berechnung des Sendebeginns erfolgt auf der Grundlage der aufbereiteten aktuellen Netzfrequenz und einer gewählten und festgelegten Nennbaudrate. Wird eine Präambel oder ein Teil davon gefunden, so wird aus der Relation der Korrelatorergebnisse ein optimaler zeitlicher Synchronpunkt ermittelt und zur weiteren Prüfung des empfangenen Bitstroms wird die Bitdauer (Bitbreite) fest auf die Nennbitbreite der sendeseitig eingestellten Baudrate gesetzt. Damit wird für die Erfassung des restlichen Telegramms eine Unabhängigkeit von der tatsächlichen Netzfrequenz erreicht. Ein weiteres Verfahren und eine Einrichtung zur Übertragung digitaler Informationen über elektrische Energieverteilnetze unter Benutzung bandspreizender Modulationsverfahren (Spread Spectrum Techniques) ist in der DE 44 23 978 A1 auf der Grundlage der europäischen Norm EN 50 065-1/1991 beschrieben.

Schließlich sind Nachrichtenübertragungssysteme, beispielsweise DAB (Digital Audio Broadcasting), bekannt, bei denen mehrere Sender gleichzeitig Senden und die Daten sich überlagern. Beispielsweise ist aus der DE 44 05 752 C1 ein Verfahren zur digitalen Rahmensynchronisation eines Übertragungssignals - das nach einem Mehrkanal-Übertragungsverfahren, insbesondere COFDM-Verfahren, erzeugt wird und eine Rahmenstruktur aufweist - bekannt, bei dem die Amplitude des Empfangssignals in einem oder mehreren Zeitschlitzen des Übertragungsrahmens ausgewertet wird. Im einzelnen erfolgt nach einer Umsetzung des Empfangssignals ins Basisband oder in eine Zwischenfrequenzlage eine Analog/Digital-Wandlung und das digitale Signal wird gleichgerichtet und in einem Matched Filter gefiltert und das gefilterte Signal wird zur Steuerung der Rahmensynchronisation verwendet.

Wie die vorstehende Würdigung des Standes der Technik aufzeigt, ist für unterschiedlich ausgestaltete Nachrichtenübertragungssysteme die Verwendung einer Präambel am Beginn eines Sendetelegramms in einem Kommunikationssystem mit burstartiger Übertragung bekannt. Der erste Teil dieser Präambel kann zu Einstellung der AGC herangezogen werden, wie dies beispielsweise in dem internationalen Patentanmeldung WO 97/14241 A1 beschrieben ist. Darüber hinaus ist der Gebrauch von Synchronisationssequenzen zur Rahmensynchronisation, d.h. zur Detektion des Telegrammbeginns einerseits und zur Trennung von Empfangsbereichen andererseits aus der US 43 87 371 A1 bekannt. Im einzelnen erfolgt beim Datenübertragungssystem gemäß der US 43 87 371 A1 die Unterscheidung zwischen Rundsenden durch eine erste Präambel und die gezielte Adressierung der einzelnen Datenempfänger durch das Senden jeweils zueinander verschiedener Präambeln. Empfangsseitig sind somit zwei Komparatoren für die zwei Präambeldetektionen erforderlich.

In der Regel wird bei bekannten Systemen zwischen dem ersten Präambelteil, der zur Einstellung der AGC dient und der eigentlichen Synchronisationssequenz, entweder zu Lasten der Effizienz eine Sendepause eingefügt ( 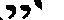 dead time" bei der internationalen Patentanmeldung WO 97/14241 A1) oder aber es wird eine erhöhte Fehldetektion in Kauf genommen, weil im allgemeinen der erste und zweite Präambelteil eine statistische Verwandtschaft besitzen, d.h. nicht unkorreliert sind.

Der Erfindung liegt gegenüber den bekannten Verfahren zur Rahmensynchronisation die Aufgabe zugrunde, dieses derart auszugestalten, dass - bei blockweiser Übertragung von Daten - ein schnelles und sicheres Einschwingen der AGC gewährleistet ist und darüber hinaus - ohne Effizienzverlust durch Verwendung von Sendepausen - eine zuverlässige Synchronisation und Signalisierung ermöglicht wird, bei der Fehldetektionen möglichst ausgeschlossen werden.

Diese Aufgabe wird, ausgehend von einem Verfahren zur digitalen Rahmensynchronisation eines Übertragungssignals mit den Merkmalen im Oberbegriff des Patentanspruchs 1, dadurch gelöst, dass die Präambel aus einem AGC-Block zum Einschwingen der AGC-Regelung und einer Synchronisationssequenz zur Rahmensynchronisation sowie zur Signalisierung besteht und dass der verfügbare Frequenzbereich im Basisband in drei überlappungsfreie Teile derart aufgeteilt wird, dass dem Bereich um die Frequenz Null der AGC-Block zugeordnet ist und dass die Unterscheidung von Signalisierungen nach Maßgabe der Übertragung der Synchronisationssequenzen in der Regel- oder Kehrlage erfolgt.

Beim erfindungsgemäßen Verfahren erfolgt im Vergleich zum vorstehend gewürdigten Stand der Technik erstmalig eine systematische Aufteilung des für die Übertragung verfügbaren Basisband-Frequenzbereichs in überlappungsfreie Teile für Synchronisationssequenzen einerseits und einem AGC-Block andererseits. Es ist auch keine TDMA-Struktur oder die Erzeugung eines separaten Pilotsignals erforderlich, wie beim Gegenstand der DE 195 11 403 A1 bzw. DE 195 11 404 A1. Die erfindungsgemäße Rahmensynchronisation weist zudem den Vorteil auf, dass der AGC-Block ein konstantes Signal darstellt, da er den Frequenzbereich um die Null belegt. Während der Zeit des AGC-Vorblocks wird deshalb ein schnelles und sicheres Einschwingen der automatischen Verstärkungsregelung, d.h. ein Erreichen ihres Betriebspunktes stark erleichtert. Dieser AGC-Block korreliert nicht mit den Synchronisationssequenzen, so dass beispielsweise 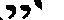 falsche Alarme" bei der Anwendung in einem PLC-System ausgeschlossen sind und dieser in Kombination mit verschiedenen Synchronisationssequenzen variabler Länge einsetzbar ist. Die einzelne Synchronisationssequenz kann gemäß der Einseitenbandmodulation entweder den Bereich positiver (sog. Regellage) oder negativer Frequenzen (sog. Kehrlage) belegen, wodurch diese in vorteilhafter Weise zur Unterscheidung von Signalisierungen herangezogen werden kann.

In diesem Zusammenhang kann noch auf die DE 43 29 898 A1, welche ein kabelloses medizinisches Diagnose- und Überwachungsgerät beschreibt, und die JP-A-08298682, welche ein Funkübertragungssystem und eine zugehörige Empfängereinrichtung beschreibt, hingewiesen werden.

Jeder Datenburst beim Diagnose- und Überwachungsgerät gemäß der DE 43 29 898 A1 enthält neben Nutzdaten noch eine Präambel, bestehend aus Synchronisiervorlauf, Burstbeginnkennzeichen, Absenderadressen und eventuell weitere systeminterne Signalisierungsdaten. Ein Hinweis, wie beim erfindungsgemäßen Verfahren die Synchronisationssequenz sowohl zur Rahmensynchronisation als auch zur Signalisierung zu verwenden, ist hieraus nicht entnehmbar.

Der Datenburst beim Funkübertragungssystem gemäß der JP-A-08298682 enthält neben Nutzdaten eine Präambel, welche aus mehreren Blöcken besteht, u.a. einem AGC-Block und einem Synchronisationsblock. Für den AGC-Block wird ein nichtmoduliertes Signal mit konstanter Einhüllender, also ein im Basisband konstantes Signal, verwendet. Im Synchronisationsblock wird die Phase des Trägersignals an jeder Sync-Symbolgrenze um *Π* geshiftet, um die Detektionsempfindlichkeit zu verbessern. Der AGC-Block dient ausschließlich zum Einschwingen der AGC-Regelung und durch die Wahl eines konstanten Signals wird dieser Block auch in den Bereich um die Frequenz Null gelegt. Der JP-A-08298682 ist jedoch kein Hinweis auf das erfindungsgemäße Verfahren zu entnehmen, nämlich eine systematische Aufteilung des für die Übertragung verfügbaren Basisband-Frequenzbereichs in überlappungsfreie Teile durchzuführen und Teile einerseits für den AGC-Block und andererseits für den Synchronisationsblock zu nutzen. Gleiches gilt für die getrennte Nutzung der beiden Frequenzbänder, die für die Synchronisationssequenz zur Verfügung gestellt werden und wodurch eine Unterscheidung von Signalisierungen anhand der Frequenzlage (Regel-/Kehrlage) der Synchronisationssequenz ermöglicht wird.

Weiterhin wird diese Aufgabe, ausgehend von einer Vorrichtung zur digitalen Rahmensynchronisation eines Übertragungssignals mit den Merkmalen im Oberbegriff des Patentanspruchs 7, dadurch gelöst, dass sende- und empfangsseitig die Präambel, welche aus einem AGC-Block zum Einschwingen der AGC-Regelung und einer Synchronisationssequenz zur Rahmensynchronisation sowie zur Signalisierung besteht, jeweils in einem mit einem digitalen Signalprozessor in Verbindung stehenden Festwertspeicher gespeichert ist, und dass der digitale Signalprozessor sende- und empfangsseitig jeweils mit einer Einrichtung zur Frequenzumsetzung verbunden ist, wobei sendeseitig der verfügbare Frequenzbereich im Basisband in drei überlappungsfreie Teile aufgeteilt wird, wobei dem Bereich um die Frequenz Null der AGC-Block zugeordnet ist und wobei die Signalisierung im Quittungsbetrieb nach Maßgabe der Übertragung der Synchronisationssequenz in der Regel- oder Kehrlage erfolgt und wobei empfangsseitig die Verschiebung des Empfangssignals in das Basisband erfolgt.

Die erfindungsgemäße Vorrichtung weist den Vorteil auf, dass die Auswertung der Signalisierung sehr einfach und die Synchronisation durch einige wenige Baugruppen digital realisiert werden kann. Dabei ist es auch möglich, einen ohnehin vorhandenen Mikroprozessor zur Detektion mitzubenutzen.

Bei einer bevorzugten Ausgestaltung der Erfindung gemäß Patentanspruch 2, wird genau eine Synchronisationssequenz benutzt und die Synchronisationssequenz in der Regellage kennzeichnet einen Burst als Sendetelegramm und in der Kehrlage als zugehörige Quittung oder umgekehrt.

Diese Ausgestaltung der Erfindung weist die Vorteile auf, dass durch die Lage der Synchronisationssequenz auf überraschend einfache Art und Weise die Kennzeichnung des Telegramms als Quittung erfolgen kann.

In Weiterbildung der Erfindung kennzeichnet, gemäß Patentanspruch 3, die Synchronisationssequenz in der Regellage eine Signalübertragung in Richtung Punkt-zu-Mehrpunkt und in der Kehrlage eine Signalübertragung in Richtung Mehrpunkt-zu-Punkt oder umgekehrt.

Diese Weiterbildung der Erfindung weist den Vorteil auf, dass eine Adressierungsinformation dahingehend, nämlich ob das Telegramm von der Zentrale (Master) oder vom Teilnehmer stammt, zur Verfügung steht. Teilnehmer, welche ein Telegramm von einem Teilnehmer 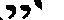 mithören", d.h. ein Quittungstelegramm, werden nicht aktiv, da diese ein Telegramm von der Zentrale erwarten.

Vorzugsweise werden, gemäß Patentanspruch 5, als Synchronisationssequenzen linear frequenzmodulierte Signale oder Chirp-Signale benutzt.

Diese Ausführungsform weist den Vorteil, dass sich Synchronisationssequenzen mit konstanter Amplitude im Zeitbereich und rechteckförmigen Amplitudenverlauf im Frequenzbereich erzeugen lassen. Mit der ersten Eigenschaft sind maximale Energieeffizienz und sehr geringe Schwankungen der Einhüllenden des Sendesignals gewährleistet. Darüber hinaus sorgt die zweite Eigenschaft für ein impulsförmiges Autokorrelationssignal. Durch die spektrale Überlappungsfreiheit der Synchronisationssequenzen sind diese statistisch unkorreliert und somit ist eine sichere Signalisierung gegeben. Im Vergleich zum Synchronisationsverfahren gemäß der DE 197 04 018 A1 wirken sich schmalbandige Störsignale, welche für PLC-Systeme charakteristisch sind und beim Gegenstand der DE 197 04 018 A1 beim Zusammenfallen mit der 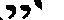 1"- oder 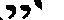 0"-Frequenz (z.B. 115,2 kHz und 105,6 kHz) zum Verlust der Synchronisation führen, nicht aus.

Weitere Vorteile und Einzelheiten lassen sich der nachfolgenden Beschreibung einer bevorzugten Ausführungsform der Erfindung unter Bezugnahme auf die Zeichnung entnehmen. In der Zeichnung zeigt:
- FIG. 1: ein Sendetelegramm mit einer den Daten vorangestellten Präambel, wobei diese wiederum aus einem AGC-Block und einer Synchronisationssequenz besteht,
- FIG. 2: die Aufteilung des Frequenzbereichs in drei Teile für den AGC-Block und die Synchronisationssequenz in Regel- und Kehrlage,
- FIG. 3: das Blockschaltbild einer bevorzugten Ausführungsform der erfindungsgemäßen Sendereinrichtung und
- FIG. 4: das Blockschaltbild einer bevorzugten Ausführungsform der erfindungsgemäßen Empfängereinrichtung.

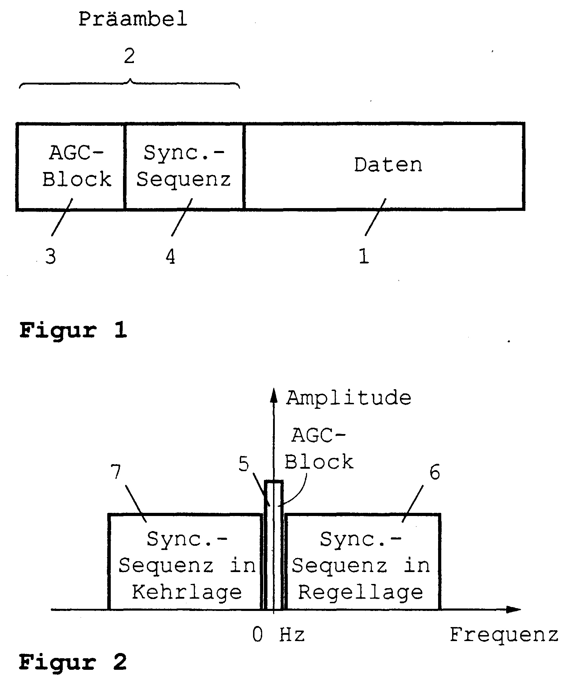

FIG. 1 zeigt den Aufbau eines Sendetelegramms zur burstartigen Übertragung in einem Multiteilnehmersystem. Den eigentlichen Daten 1 ist eine Präambel 2 vorangestellt. Die Präambel 2 setzt sich aus einem AGC-Block 3 und, gemäß der in der Zeichnung dargestellten bevorzugten Ausführungsform, aus einer Synchronisationssequenz 4 zusammen. Im Rahmen der Erfindung können auch mehrere Synchronisationssequenzen mit 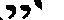 Rechteck-Spektrum" und konstantem Betrag im Zeitbereich benutzt werden. Der Nachteil der Verbreiterung der Autokorrelierten mit größerem Nebenmaxima, infolge der rechteckigen spektralen Begrenzung, ist bei zwei Synchronisationssequenzen zu vernachlässigen.

In FIG. 2 ist die Aufteilung des verfügbaren Frequenzbereichs dargestellt. Der Bereich um die Frequenz Null wird dem AGC-Block 5 zugewiesen, wodurch dieser ein zeitlich konstantes Signal ist. Die Rahmensynchronisation kann wahlweise durch eine Synchronisationssequenz in Regellage 6 oder in Kehrlage 7 erfolgen. Als Synchronisationssequenzen mit rechteckförmigen Amplitudenverlauf im Frequenzbereich sind, wie bereits erwähnt, Chirp-Signale mit komplexen Werten im Basisband geeignet.

In einem ALOHA-System mit einer Zentrale, nachfolgend Master genannt, und mehreren Teilnehmern, nachfolgend Slaves genannt, wird beispielsweise zur Signalisierung vereinbart, dass eine gesendete Synchronisationssequenz in Regellage 6 ein normales Telegramm mit Daten kennzeichnet, während eine Synchronisationssequenz in Kehrlage 7 nur die Quittung (Acknowledgement) eines korrekt empfangenen Telegramms repräsentiert.

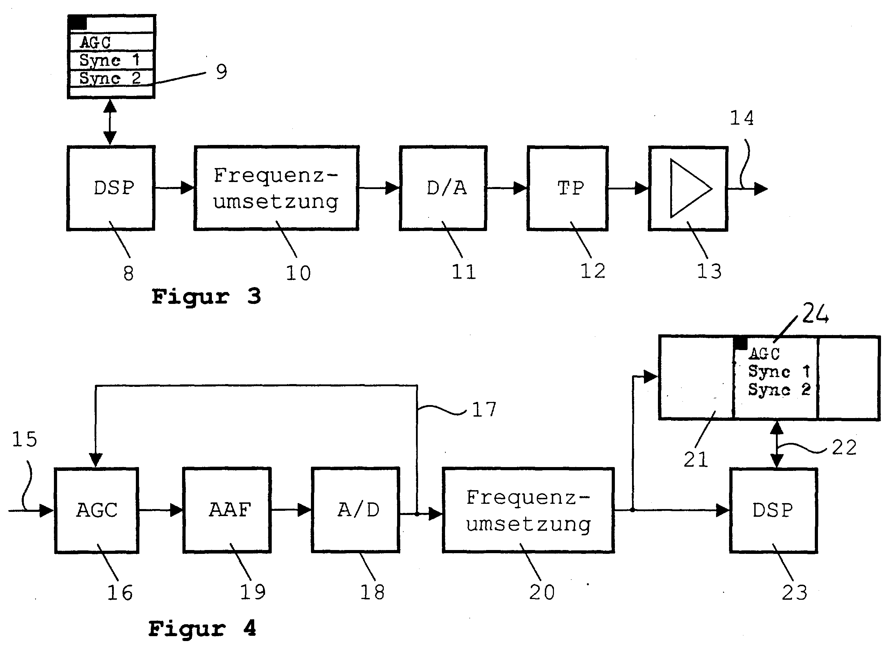

In FIG. 3 ist ein Blockschaltbild einer bevorzugten Ausführungsform der Sendereinrichtung gezeigt. Die Daten werden in einem digitalen Signalprozessor 8 erzeugt. Die Werte der Präambelfolge, d.h. des AGC-Blocks 3 und die Synchronisationssequenzen 6, 7 können in einem Festwertspeicher 9 abgelegt sein. Der digitale Signalprozessor 8 liest aus den Speicherbereichen AGC, Sync 1 und Sync 2 des Festwertspeichers 9 die benötigten Werte aus und stellt das Sendetelegramm zusammen, welches im allgemeinen durch eine zeitdiskrete Folge komplexer Werte repräsentiert wird. Anschließend erfolgt eine Frequenzumsetzung 10, d.h. das Sendetelegramm wird vom Basisband in einen höheren Frequenzbereich verschoben, wodurch sich eine zeitdiskrete reelle Folge ergibt. Vorzugsweise wird im Rahmen der Frequenzumsetzung eine digitale Interpolation der Folge durchgeführt. Der D/A-Umsetzer 11 wandelt die zeitdiskrete Folge in ein zeitkontinuierliches Signal um. Durch den Tiefpaßfilter 12 wird eine Interpolation, d.h. eine "Glattung" des Signals erreicht. Mittels des Verstärkers 13 wird die Signalamplitude geeignet angehoben, bevor das Signal über die Verbindung 14 mit einer entsprechenden Kopplungseinrichtung in den Übertragungskanal eingespeist wird.

FIG. 4 zeigt ein Blockschaltbild einer bevorzugten Ausführungsform der zugehörigen Empfängereinrichtung. Das Empfangssignal wird über eine Verbindung 15 einer automatischen Verstärkungsregelung 16 zugeführt. Diese besteht im allgemeinen aus einem klassischen einschleifigen Regelkreis mit einem regelbaren Verstärker und der Rückkopplungsgröße 17, d.h. dem Ausgangssignal des A/D-Umsetzers 18. Ein Antialiasingfilter 19 dient dabei der Bandbegrenzung zur Vermeidung sog. Überlappungsfehler. Danach wird die Empfangsfolge durch eine Frequenzumsetzung 20 in das Basisband verschoben. Vorzugsweise wird im Rahmen der Frequenzumsetzung eine Dezimation der Folgen durchgeführt.

In einer Einrichtung zur Rahmensynchronisation 21 kann mit Hilfe eines Korrelators, eines Festwertspeichers 24 und nachfolgender Schwellwertentscheidung der Blockanfang detektiert und über die Verbindung 22 einem digitalen Signalprozessor 23 die Rahmensynchronisation entsprechend signalisiert werden. Des weiteren kann dem digitalen Signalprozessor 23 anhand der Frequenzlage der Synchronisationssequenz mitgeteilt werden, ob ein normales Telegramm oder eine Quittung empfangen wurde.

Alle dargestellten und beschriebenen Ausführungsmöglichkeiten, sowie alle in der Beschreibung und/oder der Zeichnung offenbarten neuen Einzelmerkmale und ihre Kombination untereinander, sind erfindungswesentlich. Beispielsweise kann zur Approximation einer Synchronisationssequenz mit konstantem Betrag im Zeitbereich und mit rechteckförmigen Amplitudenverlauf im Frequenzbereich ein Iterationsverfahren nach Bömer, Dissertation 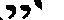 Sequenzen und Arrays mit guten aperiodischen und periodischen Autokorrelationsfunktionen" ,VDI-Verlag 1991, Seite 12 ff. benutzt werden; es kann ein konstanter AGC-Block der Länge 15 und Synchronisationssequenzen der Länge 25 benutzt werden; es kann eine weitergehende Aufteilung des Frequenzbereichs dahingehend erfolgen, dass der Bereich Kehr - und Regellage nochmals unterteilt wird und damit eine anspruchsvollere Signalisierung mit beispielsweise vier unterscheidbaren Synchronisationssequenzen ermöglicht wird u.a.

## Patentansprüche

1. Verfahren zur digitalen Rahmensynchronisation eines Übertragungssignals, bei dem die Signalübertragung in Form von Bursts sowohl in Richtung Punktzu-Mehrpunkt als auch in Richtung Mehrpunkt-zu-Punkt im Vielfachzugriff erfolgt und bei dem die Bursts neben den Nutzdaten (1) eine Präambel (2) aufweisen, **dadurch gekennzeichnet**, dass die Präambel (2) aus einem AGC-Block (3) zum Einschwingen der AGC-Regelung und einer Synchronisationssequenz (4) zur Rahmensynchronisation sowie zur Signalisierung besteht und dass der verfügbare Frequenzbereich im Basisband in drei überlappungsfreie Teile (5, 6, 7) derart aufgeteilt wird, dass dem Bereich um die Frequenz Null der AGC-Block (5) zugeordnet ist und dass die Unterscheidung von Signalisierungen nach Maßgabe der Übertragung von Synchronisationssequenzen (4) in der Regel- oder Kehrlage (6, 7) erfolgt.

2. Verfahren nach Anspruch 1, **dadurch gekennzeichnet**, dass genau eine Synchronisationssequenz (4) benutzt wird und dass die Synchronisationssequenz (4) in der Regellage einen Burst als Sendetelegramm und in der Kehrlage als die zugehörige Quittung kennzeichnet oder umgekehrt.

3. Verfahren nach Anspruch 1 oder 2, **dadurch gekennzeichnet**, dass die Synchronisationssequenz (4) in der Regellage eine Signalübertragung in Richtung Punkt-zu-Mehrpunkt und in der Kehrlage eine Signalübertragung in Richtung Mehrpunkt-zu-Punkt kennzeichnet oder umgekehrt.

4. Verfahren nach Anspruch 1, **dadurch gekennzeichnet**, dass das Burstsignal sendeseitig moduliert, d.h. vom Basisband in einen anderen Frequenzbereich verschoben und empfangsseitig demoduliert wird und dass die Synchronisationssequenzen (4) einen rechteckförmigen Amplitudenverlauf im Frequenzbereich aufweisen.

5. Verfahren nach einem oder mehreren der Ansprüche 1 bis 4, **dadurch gekennzeichnet**, dass als Synchronisationssequenzen (4) linear frequenzmodulierte Signale oder Chirp-Signale benutzt werden.

6. Verfahren nach einem oder mehreren der Ansprüche 1 bis 5, **dadurch gekennzeichnet**, dass eine weitergehende Aufteilung des Frequenzbereichs im Bereich der Kehr- und Regellage in überlappungsfreie Teile erfolgt, wodurch mehr als zwei Synchronisationssequenzen für anspruchsvolle Signalisierungsaufgaben zur Verfügung stehen.

7. Vorrichtung zur digitalen Rahmensynchronisation eines Übertragungssignals, bei dem die Signalübertragung in Form von Bursts sowohl in Richtung Punktzu-Mehrpunkt als auch in Richtung Mehrpunkt-zu-Punkt im Vielfachzugriff erfolgt und bei dem die Bursts neben den Nutzdaten (1) eine Präambel (2) aufweisen, **dadurch gekennzeichnet**, dass sende- und empfangsseitig die Präambel (2), welche aus einem AGC-Block (3) zum Einschwingen der AGC-Regelung und einer Synchronisationssequenz (4) zur Rahmensynchronisation sowie zur Signalisierung besteht, jeweils in einem mit einem digitalen Signalprozessor (8, 23) in Verbindung stehenden Festwertspeicher (9, 24) gespeichert ist, und dass der digitale Signalprozessor (8, 23) sende- und empfangsseitig jeweils mit einer Einrichtung zur Frequenzumsetzung (10, 20) verbunden ist, wobei sendeseitig (10) der verfügbare Frequenzbereich im Basisband in drei überlappungsfreie Teile (5, 6, 7) aufgeteilt wird, wobei dem Bereich um die Frequenz Null der AGC-Block (5) zugeordnet ist und wobei die Signalisierung im Quittungsbetrieb nach Maßgabe der Übertragung der Synchronisationssequenz (4) in der Regel- oder Kehrlage (6, 7) erfolgt und wobei empfangsseitig (20) die Verschiebung des Empfangssignals in das Basisband erfolgt.

8. Vorrichtung nach Anspruch 7, **dadurch gekennzeichnet**, dass in der empfangsseitigen Einrichtung zur Frequenzumsetzung (20) im Rahmen der Frequenzumsetzung eine Dezimation der empfangenen Signalfolgen durchgeführt wird.
